# EUROPEAN PATENT APPLICATION

(11) **EP 2 568 399 A2**
(43) Date of publication of application: **13.03.2013**
(21) Application number: 12183391.7
(22) Date of filing: 06.09.2012
(51) Int. Cl.: G06F 17/30

(54) **Data storage method and system**

(30) Priority: 09.09.2011 GB 201115642
(71) Applicant: Onzo Limited, London WC2H 7JB (GB)
(72) Inventor: Westbrooke, Adam Richard, Sevenoaks, Kent TN14 5AQ (GB)
(74) Representative: Hill, Justin John

(57) **Abstract**

A method and apparatus for storing time series data, in which a data structure is defined comprising a plurality of consecutive slices, each slice corresponding to a time period, time series data is stored in the data structure as runs of time series data entries each having a fixed, predetermined size and being associated with a time, each run of time series data entries comprising a number of consecutive time series data values, wherein each run of time series data is stored in a slice corresponding to the time period of the times associated with the time series data entries of the run, and each run of time series data is associated with metadata identifying the duration of the run and an offset of a start time of the run from a start time of the slice in which the run is stored.

## Description

### Field of the Invention

This invention relates to a data storage method, system and computer code for the storing of data, particularly data associated with consumption of utilities such as gas, water and electricity.

### Background

There is an ongoing and urgent need to reduce consumption of energy and water both for environmental and cost reasons.

A large proportion of the energy and water supplied by utilities suppliers is wasted as a result of inefficiencies such as use of electrical appliances that have poor efficiency or for behavioural reasons such as appliances that are left switched on and so consume electricity even when not in use, or excessive consumption of water. This leads to wastage and increased utilities costs. Moreover, with respect to electricity, electrical energy use in buildings accounts for a very large proportion of all carbon emissions. Demand for utilities can vary dramatically between identical buildings with the same number of occupants, and this suggests that reducing waste through behavioural efficiency is essential. Therefore, efforts are required to change the patterns of utilities use by consumers.

The utilities suppliers recognise three major obstacles to progress in this objective: a shortage of sources of competitive advantage, a lack of detailed understanding of their customers, and a lack of "touch points", i.e. ways of interacting with the customers. Opportunities for differentiation revolve mainly around price and "green" issues, i.e. reduction of environmental impact. The utilities suppliers have very little information about their customers' behaviour since electricity, gas and water meters collect whole house data continuously and are read infrequently.

Meters to measure total consumption of utilities of a household are commonplace for each of gas, electricity and water, however this total is not useful in identifying areas in which efficiencies may be possible (for brevity, we refer herein to a "household", however it will be appreciated that the present invention is not limited to a domestic house but may be applied to any domestic, workplace or other setting that receives its own discrete utilities supplies, in particular mains electricity supply from an electricity grid; water supply; and / or gas supply).

Apparatus for monitoring consumption of a resource such as electricity supplied on a cable is disclosed in WO 2008/142425. While a meter of this type is beneficial in assisting a user to review energy consumption patterns, when the meter is operated in a high resolution mode, for example measuring power consumption at one second intervals, and the meters are supplied to large numbers of utility customers there is a problem in storing the relatively large amount of power consumption data produced by the many different meters for subsequent processing and analysis without excessive demands for computing resources.

The power consumption data may, for example, be stored and subsequently processed by applications such as analysis of household power consumption by an end-user or by a utility supplier, or monitoring occupancy and activity within a household

It is therefore an object of the invention to provide a data processing method to allow the storage and recovery of large amounts of utilities consumption data from many different households.

### Summary of the Invention

According to a first aspect the invention provides a method of storing time series data, in which;
a data structure is defined comprising a plurality of consecutive slices, each slice corresponding to a time period;
time series data is stored in the data structure as runs of time series data entries each having a fixed, predetermined size and being associated with a time, each run of time series data entries comprising a number of consecutive time series data values;
wherein each run of time series data is stored in a slice corresponding to the time period of the times associated with the time series data entries of the run; and
each run of time series data is associated with metadata identifying the duration of the run and an offset of a start time of the run from a start time of the slice in which the run is stored.

Preferably, each run of time series data is further associated with metadata identifying the size of each data entry in the run.

Preferably, the time series data entries are separated by fixed time intervals.

Preferably, the time series data entries are separated by variable time intervals.

Preferably, each data entry comprises a time value.

Preferably, the time value of each data entry specifies the offset time of the data entry from the start time of the slice in which the run is stored.

Preferably, a plurality of runs of time series data entries are stored in a single slice corresponding to the time period of the times associated with the time series data entries of the runs.

Preferably, the plurality of runs of time series data entries stored in a single slice all comprise time series data entries having the same fixed, predetermined size.

Preferably, a run of time series data entries stored in a slice has an associated link pointer to a subsequent run of time series data entries stored in said slice.

Preferably, each slice of the data structure is referenced by index data identifying the start location of the slice.

Preferably, the plurality of runs of time series data stored in a single slice are subsequently combined to form a single run of time series data.

Preferably, the plurality of runs of time series data are combined as part of a scheduled process.

Preferably, the plurality of runs of time series data are combined in response to a request for the slice.

Preferably, when new time series data is received and stored in the data structure, the resulting changed stored data is analysed.

Preferably, when old data is deleted from the data structure, the resulting changed stored data is not analysed.

Preferably, the runs of time series data entries each comprise a time series of utility consumption values measured at a series of different times.

Preferably, each run of time series data entries comprises a time series of utility consumption values for a single consumer.

Preferably, each run of time series data entries comprises a time series of utility consumption values for a single household.

Preferably, the utility is at least one of: gas, electricity and water.

Preferably, the utility is electricity.

Preferably, the measured electricity consumption data includes data of real power.

Preferably, the measured electricity consumption data includes data of reactive power.

Preferably, the measured electricity consumption data includes data of reactive power and real power.

In a second aspect, the invention provides a data processing apparatus comprising means adapted to carry out the method of the first aspect.

In a third aspect, the invention provides a data processing apparatus adapted to store time series data, the apparatus comprising:
a data processor means and a data storage means, the data processor means being adapted to:
   define a data structure comprising a plurality of consecutive slices, each slice corresponding to a time period;
   store time series data in the data storage means using the data structure as runs of time series data entries each having a fixed, predetermined size and being associated with a time, each run of time series data entries comprising a number of consecutive time series data values;
   store each run of time series data in a slice corresponding to the time period of the times associated with the time series data entries of the run; and
   store each run of time series data in association with metadata identifying the duration of the run and an offset of a start time of the run from a start time of the slice in which the run is stored.

In a fourth aspect, the invention provides a computer program adapted to perform the method of the first aspect.

In a fifth aspect, the invention provides a computer program comprising software code adapted to perform the method of the first aspect.

In a sixth aspect, the invention provides a computer program comprising software code adapted to perform steps of:
defining a data structure comprising a plurality of consecutive slices, each slice corresponding to a time period; and
storing time series data in the data structure as runs of time series data entries each having a fixed, predetermined size and being associated with a time, each run of time series data entries comprising a number of consecutive time series data values;
wherein each run of time series data is stored in a slice corresponding to the time period of the times associated with the time series data entries of the run; and
associating each run of time series data with metadata identifying the duration of the run and an offset of a start time of the run from a start time of the slice in which the run is stored.

In a seventh aspect, the invention provides a computer readable storage medium comprising the program of any one of the fourth to sixth aspects.

In an eighth aspect, the invention provides a computer program product comprising computer readable code according to either of the fifth and sixth aspects.

In a ninth aspect, the invention provides an integrated circuit configured to perform the steps according to the first aspect.

In a tenth aspect, the invention provides an article of manufacture comprising:
a machine-readable storage medium; and
executable instructions embodied in the machine readable storage medium that when executed by a programmable system cause the system to perform the function of storing time series data comprising the steps of:
   defining a data structure comprising a plurality of consecutive slices, each slice corresponding to a time period; and
   storing time series data in the data structure as runs of time series data entries each having a fixed, predetermined size and being associated with a time, each run of time series data entries comprising a number of consecutive time series data values;
   wherein each run of time series data is stored in a slice corresponding to the time period of the times associated with the time series data entries of the run; and
   associating each run of time series data with metadata identifying the duration of the run and an offset of a start time of the run from a start time of the slice in which the run is stored.

In an eleventh aspect, the invention provides a data structure storing time series data, the data structure comprising:
a plurality of consecutive slices, each slice corresponding to a time period;
wherein the time series data is stored in the data structure as runs of time series data entries each having a fixed, predetermined size and being associated with a time, each run of time series data entries comprising a number of consecutive time series data values;
each run of time series data is stored in a slice corresponding to the time period of the times associated with the time series data entries of the run; and
each run of time series data is associated with metadata identifying the duration of the run and an offset of a start time of the run from a start time of the slice in which the run is stored.

The invention further provides systems, devices, computer-implemented apparatus and articles of manufacture for implementing any of the aforementioned aspects of the invention; computer program code configured to perform the steps according to the aforementioned method; a computer program product carrying program code configured to perform the steps according to the aforementioned method; and a computer readable medium carrying the computer program.

"Appliance" as used herein means any device that consumes one or more supplied utility, in particular gas, electricity or water.

### Description of Figures

The invention will now be described in detail with reference to the following figures in which:
Figure 1 is a diagram of a data processing system arranged to carry out the method of the present invention;
Figure 2 is an explanatory diagram of a run of time series data values according to the present invention;
Figures 3a and 3b are explanatory diagrams of a data processing concept used in the present invention;
Figures 4a and 4b are explanatory diagrams of a further data processing concept used in the present invention;
Figures 5a and 5b are explanatory diagrams of a further data processing concept used in the present invention;
Figures 6a and 6b are explanatory diagrams of a further data processing concept used in the present invention; and
Figures 7a and 7b are explanatory diagrams of a further data processing concept used in the present invention;

### Detailed Description of the Invention

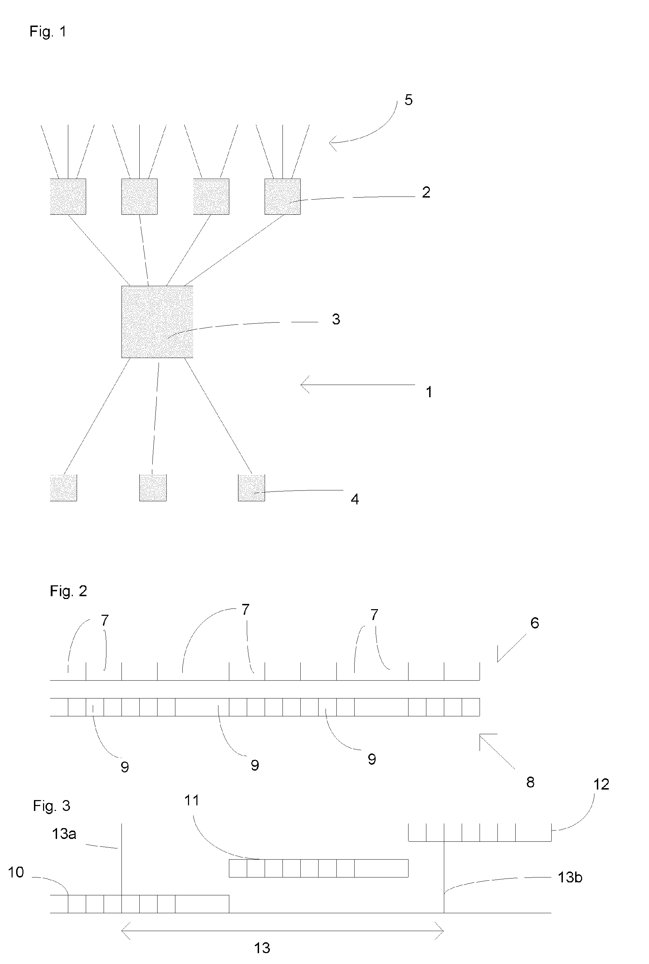

An example of a data storage method and system according to the present invention is illustrated in Figure 1 with respect to a system storing and analyzing electricity consumption data from a large number of consumers. It will be understood that the data storage method and system may be used for other purposes and that the described embodiment is described with reference to the analysis and storage of electricity consumption data as an example only.

It will be appreciated that substantially the same data storage method and system may be used for the measurement, analysis and storage of data relating to consumption of gas or water, or other utilities.

An explanatory diagram of an exemplary data processing system 1 is shown in figure 1. The data processing system 1 comprises a number of data collection servers 2, a central data storage system 3, and a number of analysis servers 4.

Electricity consumption data from consumers is supplied to the data access servers 2 of the data processing system 1 through communication links 5. The electricity consumption data from each customer relates to electricity consumption over time for that consumer, and the data from multiple consumers is gathered at each data access server and forwarded to the central data storage system 3. The total number of consumers may be relatively large. It is envisaged that in practice the data processing system 1 may store and process electricity consumption data from substantially all of the customers of an electricity utility provider, so that the electricity consumption data may relate to hundreds of thousands, or millions, of consumers.

The data access server 2 receives consumer electricity consumption data sent to the data processing system 1 and organizes the received data. When the data access server 2 has organized the received data into a suitable format, the data access server 2 supplies the formatted data to the central data storage system 3 for processing and storage. The consumer electricity consumption data received by the data access server 2 will generally mainly be new data regarding consumer electricity consumption. However, the received data may also include updated or corrected data intended to replace data provided previously. Further, the received data may also include duplicate data which duplicates data provided previously. In practice it is not expected that duplicate data will normally be deliberately sent to the data processing system 1, but this may occur inadvertently. The precise mechanism by which corrected data or duplicate data is received at the data access server 2 will depend upon how the consumer electricity consumption data is obtained and how the communication system(s) linking the electricity consumers to the data processing system 1 are organized and arranged.

In one embodiment the data processing system 1 may be supplied with customer electricity consumption data through a nodal data processing system, for example as described in GB1107993.6. In this case the data processing system 1 may be a node of the nodal data processing system.

The electricity consumption data may comprise data regarding a plurality of different measured or calculated parameter values relating to electricity consumption over time. The parameter values may for example include one, some, or all of real power, reactive power, voltage, current and frequency of an electrical utility supply, and related data, such as values derived from these parameter values. Further, the parameter values may include parameter values related to electricity consumption such as environmental data. In particular, the parameter values may include ambient temperature values over time.

A problem encountered in storing and processing electricity consumption data in detail on such a large scale is the very large amount of electricity consumption data which must be stored and be accessible to be processed, and the continuous receipt of more electricity consumption data. As a result of the very large amount of data which must be stored and the very high rate at which new data is received and must be stored and integrated with the existing stored data, it is difficult to store the electricity consumption data in a form allowing easy access and recovery of the data for future processing without the necessary computer hardware being uneconomically expensive. As a result it is desirable to increase the efficiency of storing this data.

In the illustrated example of figure 1 the number of data access servers 2, the number of analysis servers 4 and the number of communication links 5 connected to each data access server 2, and the manner in which the communication links 5 are arranged, are purely exemplary and, in practice, will depend upon the manner in which the data processing system 1 is organized and arranged.

The electricity consumers will usually be customers of an electricity utility supply company. The data processing system 1 may be operated by an electricity utility supply company to process electricity consumption data from consumers who are customers of the utility. Alternatively, the data processing system 1 may be operated by other parties, such as electricity distribution network operators or utility data analysis companies, so that the consumers are not customers of the operator of the data processing system 1.

The purpose of the data processing system 1 is to gather and store customer electricity consumption data, and related data, so that the stored electricity consumption data can subsequently be processed. This consumer electricity consumption data, and much of the related data, is in the form of time series data. In general, it is desirable to keep the data in a time series form because much of the useful content of the data relates to the different times at which events occur and the relationships between these times. Accordingly, the data processing system 1, and in particular the central data storage system 3, is required to store a very large amount of time series data.

A problem encountered in any data storage system storing time series data in a searchable and recoverable manner is that conventional database architectures are highly inefficient at storing time series data. For example, if time series data is stored in a conventional normalized SQL (Structured Query Language) database, where each data point value is represented by a single row, the stored time series data will only form a small proportion of the overall volume of data. The majority of the overall volume of data will comprise the reference keys on the data rows and indexes, which will usually be larger in data volume than the stored time series data itself. Similar problems will also arise in other known forms of database. The difficulty is not that the time series data cannot be stored, but that the total data storage capacity required to store the time series data is uneconomically large. This problem is particularly severe when storing time series data regarding electricity consumption for each of many consumers because the total amount of time series data requiring storage is so large.

The data storage method and architecture according to the present invention is intended to allow access to any range of data values for any series of data values for any of the consumers, the access allowing the data to be read out and edited.

The data storage method and architecture will be most efficient when the following conditions are met. Although the data storage architecture will still function if these conditions are not met, efficiency will be reduced.

One condition is that data usually arrives in order, that is, data relating to later times is received after data relating to earlier times.

Another condition is that data is rarely changed after it has been written into the data storage system. It should be noted that rarely is meant subjectively, i.e. that only a small proportion of the data is changed after it has been written.

Another condition is that data access is usually for pre-defined or fixed ranges, for example days, weeks or months.

Another condition is that data for a specific time series covers an extended period of time. In other words, that each time series includes a significant number of consecutive data points.

Another condition is that data is updated and/or new data is received in block of many data points at a time, rather than as single data points one by one.

It is expected that in practice these conditions will usually be met in a data processing system storing and processing consumer electricity consumption data.

The present invention provides a novel data storage method and architecture. According to the data storage method and architecture of the present invention time series data, that is a time series of data points, is stored as runs, where each run comprises a time series of consecutive data points. The data storage method and architecture of the present invention allows any stored data entry or series of data entries to be accessed for reading out or editing.

Each run is stored as a consecutive set of binary data points in the storage system used to support the data storage architecture.

It will be understood that the data storage system provided by the data storage method and architecture of the present invention will be supported by some addressable physical data storage means allowing the time series data to be stored and subsequently recovered. In order to allow such data storage and recovery to take place the individual data storage locations on the physical data storage means must have assigned addresses.

According to the present invention, where the data storage is carried out using a binary file storage approach, each run is stored as a consecutive set of binary data points in the storage system used to support the data storage architecture. In one example the consecutive set is consecutive in terms of the addressing scheme used by the physical data storage means. This approach may not be appropriate or practical when other types of data storage approach are used, such as an SQL database.

Figure 2 is an explanatory diagram showing a run 6 of a series of data values 7. The data values 7 are stored in locations on a physical data storage means having a series 8 of addresses 9 so that the series order of the data values 7 and the addresses 9 is the same.

In the present data storage architecture, each time series of data is stored as a number of slices, where each slice relates to a fixed pre-determined time range. When the time series data has a fixed interval between data values the time range of each slice will usually be a higher level of time interval than the time interval of the time series data itself. For example, time series data relating to electricity consumption at half-hourly intervals may be stored in slices representing one day of half-hourly data, or time series data relating to electricity consumption at daily intervals may be stored in slices representing one month of daily data.

It is not essential that the lengths and boundaries of the data slices correspond to conventional clock and calendar time periods, for example, hours, days, months and years, but this is usually preferred because this matches the time periods over which it is usually desired to process the electricity consumption data in order to derive useful information regarding consumer behaviour.

In general, time series data regarding a particular parameter will be received over time as number of runs of data values. In the illustrated embodiment each time series of data relating to a particular parameter from a particular consumer will be received at the central data store 3 as a number of runs of new data values from a data access server 2. The received runs of new data arriving at the central data store 3 may not begin or end at the slice boundaries. Although a received run of data may have a beginning and/or end at a slice boundary, it is not essential that this is the case.

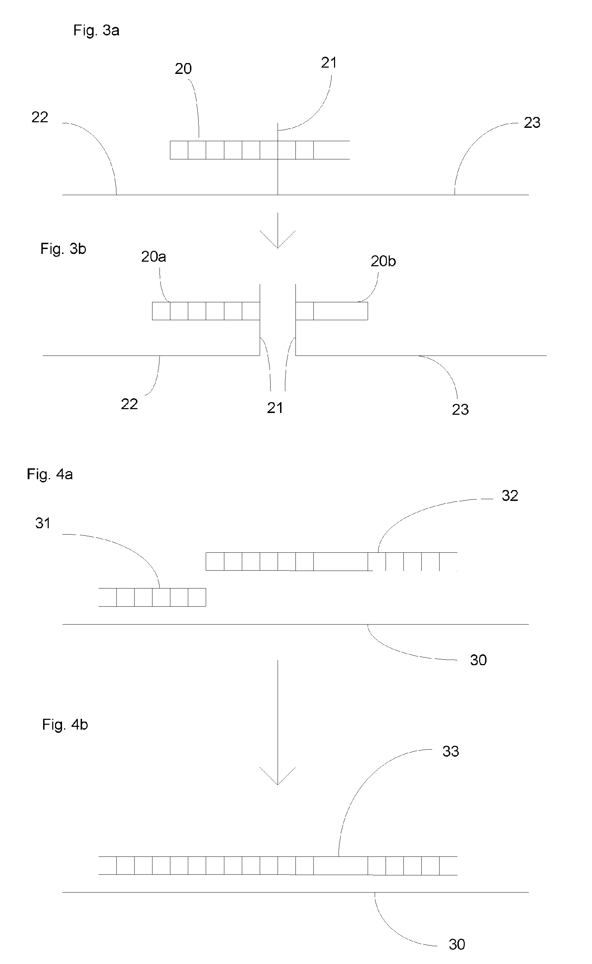

Figure 3 is an explanatory diagram showing three received runs 10, 11, 12 of electricity consumption values compared to a slice 13 having a start time 13a and an end time 13b. As is shown in figure 3, the slices 10 to 12 can overlap the start time 13a and end time 13b of the slice 13.

It is preferred that the starts and ends of new runs of received data values do not have to agree with the start and end points of slices, in order to allow the data storage architecture to easily deal with data values supplied from legacy sensors, or sensors provided by other organizations, which may be unable, or unwilling, to provide data values as runs with start and end points agreeing with the slice boundaries.

The time series data stored according to the present invention will normally fall into one of two categories. The first type of time series data is fixed interval data where the data points represent values at evenly spaced points in time. The second type of time series data is variable interval data where the data points are not necessarily evenly spaced in time. For variable interval data it will be necessary to store each data point as a value and a related time. For fixed interval data it is not necessary to store the time of each data point as part of the data point, the time associated with each data point can be deduced from the timing of the slice in which the data point is stored together with the offset and/or position in the slice of the data point.

It would be possible to include the time in each data point of fixed interval time series data. However, it is preferred not to include this time data in order to improve storage efficiency.

It should be understood that it is not necessary for the data storage architecture to have any higher level understanding of the meaning of the time series data values. For example, the time series data values could represent any parameter or parameters, and it is not necessary for the data storage architecture, or in the illustrated example the central data storage system 3, to know what this parameter or parameters are. Further, each time series data value could represent a single value of a single parameter, or multiple values of a single parameter, or values of multiple parameters. Further, the fixed interval data points could, for example, represent a value at a specific point in time or an average value over an interval. Further, the variable interval data points could, for example, represent sample points. It is not necessary for the structure or meaning of the data points to be known to the data storage architecture, or in the illustrated example the central data storage system 3. In the illustrated example the analysis servers 4 will need to be aware of the structure and meaning of the data points in order to carry out analysis of the data.

The data values of each time data series are each stored as a fixed length binary data entry. Accordingly, each time data series is stored as a series of fixed length binary data entries. Although each time data series will have a fixed size of data value, different time series of data may have different sizes of data value. In one example, the sizes of data value used for different time data series may be selectable in 1 byte increments with a minimum size of 1 byte. In one example, the sizes of data value used are selected to be multiples of four bytes, this may provide additional efficiencies.

In some examples the size of data value used for each time data series may be selected based on the anticipated properties of the data.

As discussed above, it is generally not necessary for the data storage architecture to have any higher level understanding of the meaning or structure of the time series data values. However, where a data value comprises a time value, for example where the time data series is a variable interval time data series, it may be preferred for the data storage architecture to be able to identify which part of the data value is the time value. In one example the time value part of such a data value is at a fixed location in the data value. In one example the time value is located at the start of the data value.

The data storage architecture is intended to be largely indifferent to the form and content of the data being stored. However, the data storage architecture is only intended for storing values which can be represented by a fixed length binary data notation, so that each stored data value, or entry, of a slice has the same binary size, and so occupies the same binary size of the physical data storage means. Further, the data storage architecture of the present invention is most effective when storing numeric values.

Preferably, different time series of data relating to a single consumer may be grouped together in a segment. Accordingly, each segment will comprise a number of different time data series, with each series being stored as a plurality of slices.

As mentioned above, new series data is received by the central data store 3 as runs of data points, each run of data points being related to a particular time series of data in a particular consumer segment. Each run of data will be a series of data entries of a specific, fixed, size, this size being the fixed data entry size for the data series, as discussed above.

In practice runs of new data are often received at a very high data transfer rate. Accordingly, it is preferred to save runs of new data with the minimum of processing, and to then carry out any necessary processing on the saved data, rather than attempting to process the received data on the fly before it is saved.

It should be noted that the slices storing a specific data value time series correspond to a fixed time range but may contain different amounts of data. Further, slices storing different data value time series may correspond to different time ranges and contain different amounts of data.

Each data point value corresponds to a particular time, so that each run of data values corresponds to a time range. Further, each slice in the data storage architecture corresponds to a time range. Accordingly, each data point value has a corresponding slice into which the data value should be stored. Each data value, rather than each received run of a series of data values is referred to as having a corresponding slice, because, as discussed above with reference to figure 2, it is not a requirement that the received runs of data values start or end at the boundaries of the slices, so that different data values in a received run of data values may have different corresponding slices.

This point is illustrated in figures 3a and 3b. As shown in figure 3a, a received run 20 of data values extends across a boundary 21 between consecutive slices 22 and 23. In order to store the data values the run 20 is split at the boundary 21 into two separate runs 20a and 20b. As shown in figure 3b the runs 20a and 20b are then stored in the respective slices 22 and 23. The consecutive slices 22 and 23 are shown separated in figure 3b to improve clarity, but it will be understood that the boundary 21 between them is the same time.

In the data storage architecture of the present invention the separated data runs produced by splitting a received data run at a slice boundary, for example data runs 20a and 20b, are saved into their respective corresponding slices without any record being kept that they were originally received as a single data run. This may improve the efficiency with which the data is stored by avoiding the storing of this additional data.

The illustrated example shows a run extending across a single slice boundary. There is no set limit on the length of received runs of data compared to slices, and in particular a received run may be longer than, or even multiple times longer than, a slice. As a result, a received run may be split into three or more pieces at two or more slice boundaries.

After any received run of data values extending across slice boundaries is split at the slice boundaries, the resulting runs of data values are stored in the corresponding slices. It will be understood that after any necessary splitting as described above has been carried out each run of data values will have a corresponding slice.

As discussed above, each slice corresponds to a specific time interval. Accordingly, a run of data will be stored in a slice at a position where the times of the data values of the run agrees with the timing of the slice. This is straightforward when the start of the run agrees with the start of the slice, for example as shown for run 20b in figure 3b. However, where the start of a run does not agree with the start of a slice, for example as shown for run 20a in figure 3b, the start of the run must be offset appropriately from the start of the slice, the length of the offset corresponding to the time difference. There may be multiple runs stored for each slice. These runs need not be contiguous, there may be gaps between the different runs or the different runs may overlap.

Each stored run can be identified by the segment (consumer) and time series of data the run relates to, together with the start time of the slice that the run holds data entries for. This identification data is associated with the slice into which the run is saved. In one example this data is not stored in association with the run, but only with the slice, and the run is identified with reference to the slice in which it is stored.

Each stored run has associated metadata identifying the length of each data entry of the run, the duration of the run, and the offset of the start of the run from the start of the slice. In one example the length of each data entry may be defined in bytes. Since the offset of the start of the run from the start of the slice is defined, individual data entries within the run can be located using this offset, the position of the data entry in the run, and the length of each data entry in bytes. As explained above with reference to figure 2, the data entries of each run are stored as a consecutive set of binary data points in the physical data storage system used to support the data storage architecture, the consecutive set being consecutive in terms of the addressing scheme used by the physical data storage means. Accordingly, this metadata can be used to locate individual data entries within the run in the physical data storage system.

In one example the slices can also be arranged in order to form a consecutive set of binary data points for storage. This may increase efficiency still further.

It should be noted that the start time of the slice is a time in the general sense, and not in the narrower sense of time of day. The start time may be defined as a date and a time of day.

Each run will also hold a link pointer to any follow on run for the same slice, so that the runs form a linked list of data for the slice.

In one example where the data architecture is used in an SQL server, a run is stored in a single Varbinary column on a single row. The location of the run is identified by storing index data (for example, SegmentID, TimeseriesID, SliceStart, identifying the segment and time series and the slice start time), as columns on the row. The run metadata is also stored on the SQL row.

In one example where the data architecture is used with binary file storage, a run is stored as a sequence of bytes within a larger file. A pointer to the start position is held in a separate index file, indexed with the index data (for example SegmentID, TimeseriesID, SliceStart). Metadata may be held with the run or in the index.

Where there are multiple versions of the same slice generated at different times the index points only to the address of the earliest produced version of the slice. Each version of the slice contains a pointer to the next produced version of the slice, if there is a later produced version. This may allow the index file entries to be kept to a constant minimum size, which may improve efficiency.

The index file is itself a fixed interval series, where the value is the pointer, so that index can be stored similarly to other runs of time series data as described herein. This may improve efficiency.

As discussed above, variable interval data entries comprise a value and a related time. This time value is defined and stored as an offset time from the start time of the slice in which the data entry is saved. Storing the time values as offsets may simplify the manipulation of variable interval data runs by avoiding any need to recalculate the time values when runs are manipulated.

In order to update the stored data any new or updated data is written into storage as a new run of a series of data values, or as a series of runs if the new or updated data crosses a slice boundary, in the slice or slices corresponding to the time period of the new or updated data. If there is any pre-existing run already present in the slice where the newly written run starts, the link pointer of the last pre-existing run already present in the slice where the newly written run starts is then changed to link to the start of the newly written run, to form a linked list of data for the slice.

In one example where the data architecture is used in an SQL server, new rows are created corresponding to the newly written run. Accordingly, where different versions of a slice are stored as changes are made over time, the different versions of the slice are stored as separate rows, with each row having an associated metadata field containing the update time at which the version of the slice was created or a sequence or order number. In another example using binary file storage, a new index pointer is created for the newly written run to link the different runs into a linked list where the index points to the first slice and each slice has a pointer to the following slice.

This update procedure is used to add new data, edit already stored data, or delete stored data. The present data storage architecture does not distinguish between these operations by using a different procedure, all of these operations are carried out by the same procedure of writing new run(s) of data for a time range. Where the operation is adding new data, the newly written run(s) are written into a time range for which there was previously no stored data. Where the operation is updating or editing already stored data, the newly written run(s) are written into a time range for which there was previously stored data. Where the operation is deleting already stored data, the newly written run(s) comprise a series of null values and are written into a time range for which there was previously stored data.

Nulls may also be used to pad out slices of fixed interval data values where the stored runs of fixed interval data values do not fill the slice. The use of nulls is not required in variable interval data because the intervals between the times of the data values are defined by the times of the data values, without any 'missing' values.

In one example the present data storage architecture does not distinguish between a data point that is not stored and a data point stored with a null value. This approach may simplify editing and deleting data.

Some binary storage formats for storing numeric values do not support the representation of nulls. If a binary storage format that does not support nulls is used the data storage architecture specifies a numeric value which can be recorded in the binary storage format and assigns this specified value as representing a null to the data storage architecture.

In one example, during use of the data storage architecture the stored runs of series data are manipulated and processed as a background tidying processing activity to place the stored data into the most efficient format for storage.

This tidying processing will identify slices containing more than one stored run and merge these runs together into a single continuous run.

This tidying processing is illustrated in figures 4a and 4b. As shown in figure 4a, a slice 30 contains a first run 31 of data values and a second run 32 of data values. In this example the runs 31 and 32 do not overlap, and the final entry of the first run 31 is consecutively followed by the first entry of the second run 32 so that the runs 31 and 32 follow directly on from one another. Accordingly, as shown in figure 4b the runs 31 and 32 can be concatenated to form a single run 43.

Further, this processing will identify slices containing more than one stored run and merge these runs together into a single continuous run. This processing can involve a number of possible actions.

One possible action is the concatenation of runs which follow on from one another. An example of this action is illustrated in figures 4a and 4b, and is discussed above.

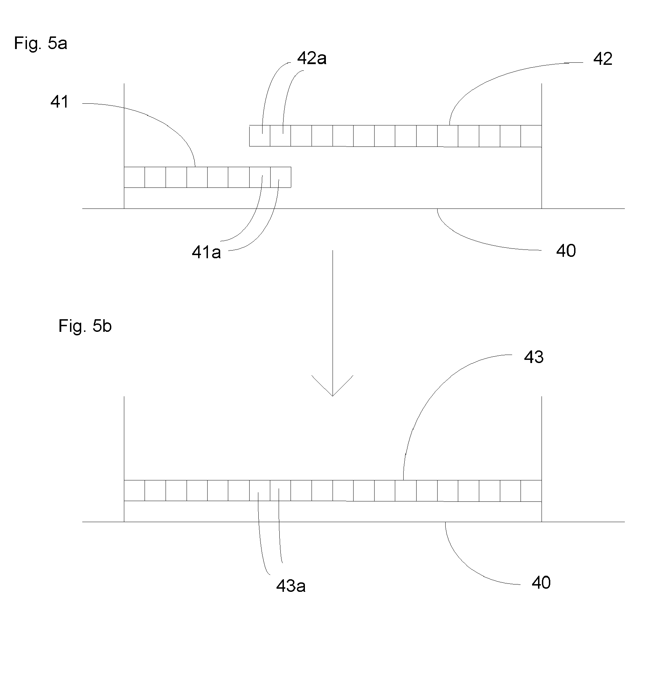

Another possible action is the combining of runs which overlap one another and the deletion of any overlapping entries. An example of this action is illustrated in figures 5a and 5b. As shown in figure 5a, a slice 40 contains a first run 41 of data values and a second run 42 of data values. In this example the runs 41 and 42 overlap, so that the final entries 41a of the first run 41 are the same as the first entries 42a of the second run 42. Accordingly, as shown in figure 5b each of the duplicated overlapping entries 41a and 42a are replaced by a single entry 43a and the runs 41 and 42 are concatenated to form a single run 43.

The overlapping entries 41a and 42a are duplicate entries in that they are entries for the same time in the time series of data values. If the overlapping entries 41a and 42a have the same value for an entry this common value is used for that entry in the corresponding single entry 43a. However, the overlapping entries 41a and 42a do not necessarily have the same value. Where the overlapping entries 41a and 42a have a different value for an entry the value of that entry in the most recently received of the overlapping runs 41 and 42 is used for that entry in the corresponding single entry 43a. It should be noted that the runs are not necessarily received in order, so that the most recently received run may not be the run relating to the most recent data values in the time series.

Where a plurality of runs received at different times have been combined into a single run the combined run no longer has a single time of receipt. Accordingly, the combined run is assigned a time of receipt value for use during subsequent combining with further runs. In one example, when a plurality of runs received at different times are combined into a single run the resulting single combined run is assigned as a time of receipt the most recent time of receipt of the different times of receipt of said plurality of runs.

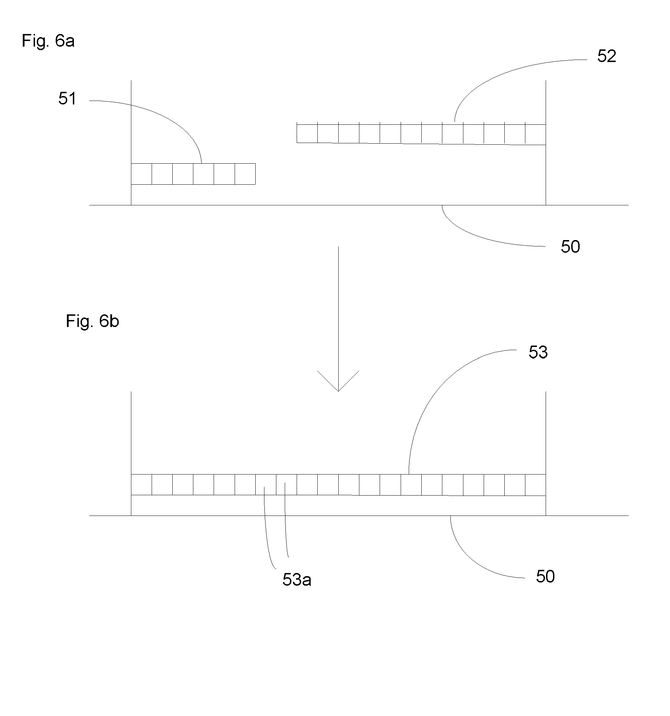

Another possible action is the combining of runs which have a gap between them and do not follow on from one another and the filling in of the gap by padding with null entries. An example of this action is illustrated in figures 6a and 6b. As shown in figure 6a, a slice 50 contains a first run 51 of data values and a second run 52 of data values. In this example the runs 51 and 52 are separated by a gap for which no data entries have been stored, so that the first entry of the second run 52 does not consecutively follow the last entry of the first run 51. Accordingly, as shown in figure 5b null entries 53a are added to fill the gap between the runs 51 and 52, and the runs 51 and 52 are concatenated together with the null entries 53a to form a single run 53. This action cannot be carried out for runs of variable interval data because the concept of a gap does not apply so that the use of nulls is not required.

In some examples it may be necessary to distinguish between two different types of null value. A first type of null value is a true null, which does overwrite the value of an earlier entry and replace the value with a null value during the update procedure described above. The true null is treated as a data value that has a value of null. A second type of null value is a transparent null, which does not overwrite the value of an earlier entry so that the value of the earlier entry is maintained during the update procedure described above.

In examples where SQL is used the distinction between two different types of null may not be required. When SQL is used padding of gaps between runs with nulls may not be necessary. Instead, each slice including gaps between runs can be stored in association with metadata identifying the offset distance from the last value of one run to the first value of the next run at each gap in the slice.

The above examples discuss only a single action being taken to combine two runs within a single slice. In principle there may be any number of runs within a single slice, although in any specific implementation there may be a limit on the maximum number of runs in a slice. Accordingly, several of the above actions may take place together in order to combine three or more runs in a single slice.

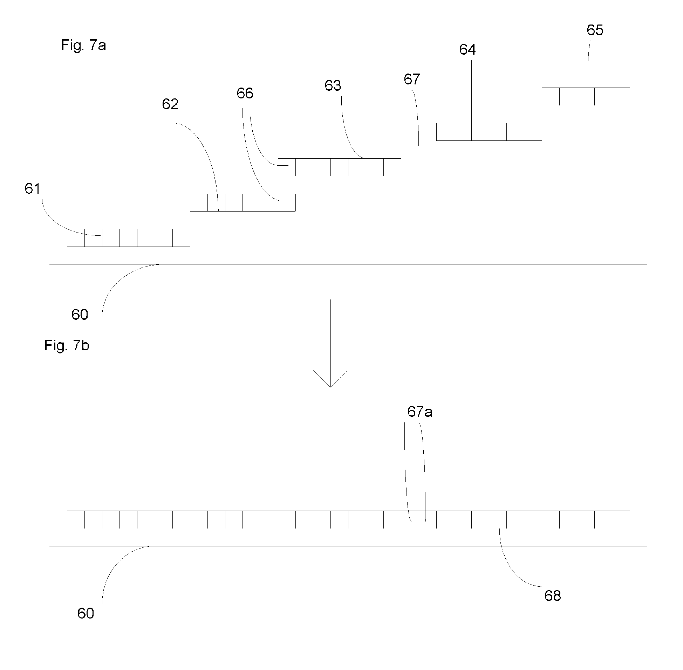

An example of this is illustrated in figures 7a and 7b. As shown in figure 7a, a slice 60 contains first to fifth runs 61 to 65 of data values. In this example the runs 61 to 65 include an overlapping part 66 for which duplicate data entries have been stored, and are separated by a gap 67 for which no data entries have been stored. Accordingly, as shown in figure 7b null entries 67a are added to fill the gap 67, each of the duplicated overlapping entries 66 are replaced by a single entry, and the runs 61 to 65 are concatenated together with the null entries 67a to form a single run 68.

After the different runs in a slice have been combined into a single run, any data which is no longer referenced can be deleted. Such data which is no longer referenced may be old copies of runs which have been merged into a single run. Further, the data which is no longer referenced may be slices which no longer contain any data, for example because they have been overwritten by nulls, or slices for which the index references have been removed.

In examples where binary file storage is being used, the storage files can be rearranged to place slices for the same segment in the same cluster. A cluster is the smallest unit of storage used by the file system on which the data is stored. A cluster is treated as a single block of data by the underlying file system used for data storage and forms the unit of data which is read or written in as a single operation by the operating system controlling the file system. Accordingly, the size of a cluster will vary depending on the data storage file system used to carry out the invention.

The background processing described above to merge all runs in each slice together into a single continuous run so that each slice contains a single continuous run of data entry values may allow the time series data to be stored and processed more efficiently.

The background processing described above may conveniently be carried out when the data is queried, if this processing has not already been carried out. This enables queries to be answered by providing continuous runs of data entries. This may improve processing efficiency.

In examples using null entries to fill, or pad, gaps, when real data values corresponding to data entries for which nulls have been used are received to the padding of a slice with null entries, the null entries should be replaced by the corresponding data values. The update procedure described above will do this automatically when the real values are been received subsequent to the combining operation in which the null entries were added was carried out. Further, in examples using two different types of null entries the use of transparent nulls to fill gaps will ensure that the null entries are replaced by the real data values even if the real values were not received subsequently to the null entries being added.

In addition to the consolidation of the data runs into slices described above, the slices themselves may be consolidated into larger slices. For example, a time series of daily data values may be stored and consolidated as monthly slices of data. The monthly slices of data may in turn be consolidated into yearly slices of data.

When a new or changed data run is written into storage from a data access server 2, the data processing architecture marks this newly written data run to indicate that the data requires assessment to determine what processing should be carried out on it. The newly written data run is designated as changed, or dirty, data to indicate that it has not yet been assessed.

Data is assessed, and analysed and processed in other ways, by the data analysis servers 4. The data access servers 4 will assess data and determine what analysis and processing of the data is required. It is expected that the data analysis servers 4 would usually carry out the required analysis and processing so that the data output from the data analysis servers 4 would be both assessed and analysed, but it may not always be possible for a data analysis server 4 to carry out the required analysis and processing, for example because some analysis and processing tasks may require special capabilities which are only possessed by some of the data analysis servers 4. However, the output data written into the central data store 3 from the data access servers 4 will always be assessed data.

Accordingly, when a new or changed data run is written into storage from a data analysis server 4, this data run is not marked to indicate that it requires assessment because the data run has already been assessed.

In operation of the data storage architecture, as new or changed data runs are written as new entries, the set of rows of the data store form a transaction log identifying the changes made, both for the addition of new data and the replacement of already stored data. This set of data also forms a list of change events that need to be processed, so that a separate event queue is not required.

In one example the background tidying processing described above is carried out only on runs of serial data values that have been assessed and analysed by a data analysis server 4 and written back into the central data store 3. In this example the set of slices containing the runs of assessed data will provide a true transaction log.

In some examples the consolidation of data runs discussed above can be extended by consolidating all of the update data so that each slice is saved as an original slice and an update or delta slice identifying the changes made to the original slice.

As discussed above the purpose of the data storage architecture is to store the time series data values efficiently in a manner allowing the stored data to be queried and recovered, for example to allow review and analysis.

The data storage architecture allows data to be read from the stored time series data for any desired range of time.

In order to do this a data retrieval process is used in which the desired time series and range of time are identified and requested from the data store. As explained above, the time series may relate to a specific parameter for a specific consumer. The stored slices which cover the desired range of time are identified.

The runs that contain data values for the identified slices are read out from storage. In one example where the data architecture is used in an SQL server, this is carried out by selecting SQL rows. In one example using binary file storage, this is done by following a linked list of binary runs.

When data is read out, if the runs making up the requested data have not already been consolidated into a single run of complete slices, these runs may be manipulated into complete slices on the fly during the read out operation using tidying processing, for example as described above with reference to figures 4 to 7. In this case the consolidated data can be written back into the central data store 3. This may improve efficiency by avoiding repeating the consolidation processing as part of the background tidying processing.

The starts and ends of the read out data run or runs are trimmed as necessary to match the end points of the requested range of time, if the end points of the requested range of time do not coincide with the end points of slices.

The read out data is then formatted into a single block of binary data containing the information from the start time to the end time. If the read out data comprises multiple slices, the read out data may be provided as a single block comprising multiple slices or as separate blocks each comprising a single slice, depending which of these formats is most suitable for the underlying database mechanism supporting the data storage architecture.

In one example the read out data does not include any time indicators (such as SQL columns) indicating the date and/or time to which the read out data corresponds. Instead, the read out data is identified as a response to the request, and the read out data is presumed to correspond to the time range identified in the request. This may improve efficiency.

In one example a data analysis server 4 may be arranged to receive read out data comprising multiple slices only in a format preferred by the database server 3. In another example a data analysis server 4 may be arranged to be able to receive read out data comprising multiple slices in either format, the format actually used in any particular case being selected by the database server supplying the data.

It should be understood that the data analysis server is not required to process the data in the same format in which it is read out of storage. However, in examples where this is done, this may improve efficiency.

The data analysis servers 4 can decode the binary data into values or structs, and process each slice as an array of these values or structs as necessary.

As explained above, queries may identify any range of times and are not limited to ranges of time starting and/or ending at the slice boundaries. However, in examples where the lengths and boundaries of the data slices correspond to conventional clock and calendar time periods, for example, hours, days, months and years, it is expected that many queries will have start and end times corresponding to slice boundaries, because these correspond to time periods that are often of interest in analysis of consumer behavior. In one example the data analysis servers may be arranged to only issue queries for complete slices, that is, queries for a range of times starting and end at slice boundaries. In examples where the range of times of queries starting and end at slice boundaries this may increase efficiency.

In some examples, when a query requests data for a range of times including an 'empty' slice for which no data values have been received the data provided in response to the query may be a null slice indicator signifying that there are no real data values recorded for the slice, rather than a run of null data values for the full length of the slice. This may improve efficiency.

The approach described above of assembling complete slices from a stored series of runs representing transactions on that slice in response to receiving a query may provide the advantage that the values of the slice before and after processing can be made available.

In some examples the consolidation process assembling complete slices from runs may produce a change record, or delta file. This change record may be used to allow before and after data to be produced.

The before values may be used in analysis as desired.

As explained above the present embodiment relates to the use of the data storage architecture in a system storing and analyzing electricity consumption data from a large number of consumers. In such a system the amount of new data being received is relatively large, and the importance and value of the stored data declines over time. Accordingly, in order to prevent the total amount of stored data becoming unmanageably large, the stored data may be pruned by removing the oldest data. Oldest being defined as the data having the greatest age, compared to the present time, for any particular time series of data values.

The data pruning process deletes data values, but although deletion is regarded as change, as a special exception this deletion is not marked as changed, or dirty, data, since this would trigger undesired analysis of the deletion. In general, the pruning can be carried out by removing the data values from the database index, and allowing the actual deletion to be carried out by a background database management process.

When data is pruned the database index should be marked to indicate that the data has been received and pruned, to prevent erroneous assumptions that the data was never received at all.

This may provide the advantage that in some circumstances it may be possible to retrieve or regenerate pruned data if it is known that the data has existed and has been deleted, rather than the data never existing at all. For example, if the data was originally provided from an external data source this data source may be queried to see if the data is still available, or if the data was obtained by calculation it may be possible to identify precursor data which will allow the pruned data to be recalculated.

In general the storage of large amounts of live data which can be backed up and amended is relatively expensive, both in system requirements and financially. Accordingly, the data storage method and architecture of the present invention allows older data to be removed from the data storage system to long term storage. This may allow costs to be reduced.

In general there are two options for doing this, placing the data on lower cost discs, and removing the requirement to back up data by using read only data archives, from which fixed backups can be taken. These backups will not require updating because the data archives themselves are read only.

In one example using binary file storage older data may be placed in different volumes, which may have different characteristics.

The slice editing approach of the present invention allows data to be marked as read only while still being available for editing, so that any slice can be marked as read only as part of an archiving strategy. Any changes made after a slice had been marked as read only would be held as a new data run entry for the slice as described above. In this case the background processing would not be able to merge the data changes made into the stored read only slice, so that subsequent access to the slice would use two, or more, run access actions thereafter and the accessed data would have to be merged before being processed.

The archiving strategy could allow for the relatively small number of changes made after slices have been archived to be resolved into the archive copy at infrequent intervals. In one example this could be carried out as a manual process ever few months. A new fixed back up could then be made.

The embodiment described above stores data segments where each data segment comprises data relating to a single consumer. In other examples other criteria may be used to organize data into segments.

The embodiment described above has all data stored in a common data store. In alternative examples different slices of data may be stored in different storage devices.

In one example changed, or dirty, data and assessed, or clean, data may be stored in different files or different storage devices. This may allow efficiency to be improved by matching the characteristics of the file structure or storage device to the likely manner in which the different types of stored data will be accessed. For example, changed, or dirty, data may need to be accessed in any order as it is processed. In contrast, assessed, or clean, data will usually be accessed in time series order.

The invention has been discussed primarily with respect to processing data regarding consumption of electricity, however it will be appreciated that the methods described herein can equally be applied to consumption of water or gas supplied to a household. The invention may also be applied to other fields such as logistics or transport systems.

Consumption of water and gas can be measured using techniques that are well known to the skilled person, for example based on use of water and gas meters. Water and gas consumption, in particular water consumption, may be measured at a lower rate, for example at least once every 300 seconds or at least once every 60 seconds, in order to generate water consumption data that may be used to identify events associated with consumption of water. The rate of flow of water or gas at each time interval may be measured, along with the total volume consumed over time in a manner analogous to power and energy measurements of electricity consumption. Additionally or alternatively, water and gas consumption may be measured at measurement points after intervals of volume consumption rather than intervals of time, for example a measurement of time elapsed for each unit volume (e.g. litre) of water to be consumed.

The apparatus described above may be implemented at least in part in software. Those skilled in the art will appreciate that the apparatus described above may be implemented using general purpose computer equipment or using bespoke equipment.

The hardware elements, operating systems and programming languages of such computers are conventional in nature, and it is presumed that those skilled in the art are adequately familiar therewith. Of course, the server functions may be implemented in a distributed fashion on a number of similar platforms, to distribute the processing load.

Here, aspects of the methods and apparatuses described herein can be executed on a computing device such as a server. Program aspects of the technology can be thought of as "products" or "articles of manufacture" typically in the form of executable code and/or associated data that is carried on or embodied in a type of machine readable medium. "Storage" type media include any or all of the memory of the computers, processors or the like, or associated modules thereof, such as various semiconductor memories, tape drives, disk drives, and the like, which may provide storage at any time for the software programming. All or portions of the software may at times be communicated through the Internet or various other telecommunications networks. Such communications, for example, may enable loading of the software from one computer or processor into another computer or processor. Thus, another type of media that may bear the software elements includes optical, electrical and electromagnetic waves, such as used across physical interfaces between local devices, through wired and optical landline networks and over various air-links. The physical elements that carry such waves, such as wired or wireless links, optical links or the like, also may be considered as media bearing the software. As used herein, unless restricted to tangible non-transitory "storage" media, terms such as computer or machine "readable medium" refer to any medium that participates in providing instructions to a processor for execution.

Hence, a machine readable medium may take many forms, including but not limited to, a tangible storage carrier, a carrier wave medium or physical transaction medium. Non-volatile storage media include, for example, optical or magnetic disks, such as any of the storage devices in computer(s) or the like, such as may be used to implement the encoder, the decoder, etc. shown in the drawings. Volatile storage media include dynamic memory, such as the main memory of a computer platform. Tangible transmission media include coaxial cables; copper wire and fiber optics, including the wires that comprise the bus within a computer system. Carrier-wave transmission media can take the form of electric or electromagnetic signals, or acoustic or light waves such as those generated during radio frequency (RF) and infrared (IR) data communications. Common forms of computer-readable media therefore include for example: a floppy disk, a flexible disk, hard disk, magnetic tape, any other magnetic medium, a CD-ROM, DVD or DVD-ROM, any other optical medium, punch cards, paper tape, any other physical storage medium with patterns of holes, a RAM, a PROM and EPROM, a FLASH-EPROM, any other memory chip or cartridge, a carrier wave transporting data or instructions, cables or links transporting such a carrier wave, or any other medium from which a computer can read programming code and/or data. Many of these forms of computer readable media may be involved in carrying one or more sequences of one or more instructions to a processor for execution.

Those skilled in the art will appreciate that while the foregoing has described what are considered to be the best mode and, where appropriate, other modes of performing the invention, the invention should not be limited to specific apparatus configurations or method steps disclosed in this description of the preferred embodiment. It is understood that various modifications may be made therein and that the subject matter disclosed herein may be implemented in various forms and examples, and that the teachings may be applied in numerous applications, only some of which have been described herein. It is intended by the following claims to claim any and all applications, modifications and variations that fall within the true scope of the present teachings. Those skilled in the art will recognize that the invention has a broad range of applications, and that the embodiments may take a wide range of modifications without departing from the inventive concept as defined in the appended claims.

Although the present invention has been described in terms of specific exemplary embodiments, it will be appreciated that various modifications, alterations and/or combinations of features disclosed herein will be apparent to those skilled in the art without departing from the spirit and scope of the invention as set forth in the following claims.

## Claims

1. A method of storing time series data, in which;
a data structure is defined comprising a plurality of consecutive slices, each slice corresponding to a time period;
time series data is stored in the data structure as runs of time series data entries each having a fixed, predetermined size and being associated with a time, each run of time series data entries comprising a number of consecutive time series data values;
wherein each run of time series data is stored in a slice corresponding to the time period of the times associated with the time series data entries of the run; and
each run of time series data is associated with metadata identifying the duration of the run and an offset of a start time of the run from a start time of the slice in which the run is stored.

2. The method according to claim 1, in which each run of time series data is further associated with metadata identifying the size of each data entry in the run.

3. The method according to claim 1 or claim 2, in which the time series data entries are separated by fixed time intervals.

4. The method according to claim 1 or claim 2, in which the time series data entries are separated by variable time intervals.

5. The method according to claim 4, in which each data entry comprises a time value.

6. The method according to claim 5, in which the time value of each data entry specifies the offset time of the data entry from the start time of the slice in which the run is stored.

7. The method according to any preceding claim, wherein a plurality of runs of time series data entries are stored in a single slice corresponding to the time period of the times associated with the time series data entries of the runs.

8. The method according to claim 7, wherein the plurality of runs of time series data entries stored in a single slice all comprise time series data entries having the same fixed, predetermined size.

9. The method according to claim 7 or claim 8, wherein a run of time series data entries stored in a slice has an associated link pointer to a subsequent run of time series data entries stored in said slice.

10. The method according to any preceding claim, wherein each slice of the data structure is referenced by index data identifying the start location of the slice.

11. The method according to any one of claims 7 to 9, wherein the plurality of runs of time series data stored in a single slice are subsequently combined to form a single run of time series data.

12. The method according to claim 11, wherein the plurality of runs of time series data are combined as part of a scheduled process.

13. The method according to claim 11, wherein the plurality of runs of time series data are combined in response to a request for the slice.

14. The method according to any preceding claim, wherein when new time series data is received and stored in the data structure, the resulting changed stored data is analysed.

15. The method according to claim 14, wherein, when old data is deleted from the data structure, the resulting changed stored data is not analysed.

16. The method of any preceding claim, wherein the runs of time series data entries each comprise a time series of utility consumption values measured at a series of different times.

17. The method of claim 16, wherein each run of time series data entries comprises a time series of utility consumption values for a single consumer.

18. The method of claim 16, wherein each run of time series data entries comprises a time series of utility consumption values for a single household.

19. The method of claim 16 or claim 17, wherein the utility is at least one of: gas, electricity and water.

20. The method according to claim 19, wherein the utility is electricity.

21. The method according to claim 20, wherein the measured electricity consumption data includes data of real power.

22. The method according to claim 20, wherein the measured electricity consumption data includes data of reactive power.

23. The method according to claim 20, wherein the measured electricity consumption data includes data of reactive power and real power.

24. A data processing apparatus comprising means adapted to carry out the method as set out in any one of claims 1 to 23.

25. A computer program comprising instructions which, when executed by a processor, will cause the processor to perform the method of any one of claims 1 to 23.

26. A data structure storing time series data, the data structure comprising:
a plurality of consecutive slices, each slice corresponding to a time period;
wherein the time series data is stored in the data structure as runs of time series data entries each having a fixed, predetermined size and being associated with a time, each run of time series data entries comprising a number of consecutive time series data values;
each run of time series data is stored in a slice corresponding to the time period of the times associated with the time series data entries of the run; and
each run of time series data is associated with metadata identifying the duration of the run and an offset of a start time of the run from a start time of the slice in which the run is stored.
